Europäisches Patentamt

**European Patent Office**

**Office européen des brevets**

(19)

(11) Veröffentlichungsnummer : **0 000 545**
**B1**

(12) **EUROPÄISCHE PATENTSCHRIFT**

(45) Veröffentlichungstag der Patentschrift :
**11.02.81**

(51) Int. Cl.³ : **H 01 L 21/00**, H 01 L 29/08,
**H 01 L 21/265**

(21) Anmeldenummer : **78100443.7**

(22) Anmeldetag : **19.07.78**

(54) **Verfahren zur Herstellung einer Halbleiteranordnung mit Selbstjustierung.**

(30) Priorität : **01.08.77 US 820991**

(43) Veröffentlichungstag der Anmeldung :
**07.02.79 (Patentblatt 79/03)**

(45) Bekanntmachung des Hinweises auf die Patenterteilung : **11.02.81 Patentblatt 81/06**

(84) Benannte Vertragsstaaten :
**BE DE FR GB NL SE**

(56) Entgegenhaltungen :
**DE - A - 2 726 003**
**FR - A - 2 334 198**
**GB - A - 1 348 066**
**US - A - 3 936 857**
**US - A - 4 029 522**

(73) Patentinhaber : **International Business Machines Corporation**

**Armonk, N.Y. 10504 (US)**

(72) Erfinder : **JAMBOTKAR, Chakrapani Gajanan**
**154 Hosner Mountain Road**
**Hopewell Junction New York 12533 (US)**

(74) Vertreter : **Mönig, Anton, Dipl.-Ing.**
**Schönaicher Strasse 220**
**D-7030 Böblingen (DE)**

Imprimerie Jouve, 17, rue du Louvre, 75001 Paris, France

## Verfahren zur Herstellung einer Halbleiteranordnung mit Selbstjustierung

Die Erfindung bezieht sich auf ein Verfahren zur Herstellung einer Halbleiteranordnung der im Oberbegriff des Patentanspruchs 1 angegebenen Art. Bevorzugtes Anwendungsgebiet dieses Verfahrens ist die Herstellung von Isolierschicht-Feldeffekttransistorstrukturen, die mit sog. selbstjustierten Gate-Elektroden ausgestattet sind.

Derartige Feldeffekttransistoren mit selbstjustiertem Gate sind an sich bereits bekannt. Die zugehörigen konventionellen Herstellungsverfahren verwenden für die Maskierung während der Ausbildung der Source- und Draingebiete eine Maske aus einem hochtemperaturfesten Material, d.h. einem Material, das in der Lage ist, hohe Temperaturen in der Größenordnung von 1000 °C und höher auszuhalten. Diese Maskierungsschicht kann beispielsweise aus Silicium bestehen, wie für die in den US-Patentschriften 3 475 234 und 3 544 399 behandelten Verfahren beschrieben ist, wobei polykristallines Silicium als Maskierungsmaterial benutzt wird, das im Gate-Bereich zur letzlichen Bildung der Gate-Elektrode verbleibt. Da es sich bei solchen Strukturen um Isolierschicht-Feldeffekttransistoren handelt, wird stets noch eine Schicht aus einem isolierenden Material, z.B. aus Siliciumdioxid, unter der Silicium enthaltenden Maskierungsschicht vorhanden sein.

Andererseits kann das hochtemperaturfeste Material selbst bereits ein isolierendes Material sein, z.B. Siliciumnitrid, das als Gate-Dielektrikum im Gate-Bereich verbleibt. Zugehörige Verfahren dieser Art sind in der US-Patentschrift 3 544 858 behandelt. Dabei dient das hochtemperaturfeste Material, z.B. Siliciumnitrid oder eine Doppelschicht aus Siliciumnitrid über Siliciumdioxid, zur Kantendefinition der an den Gate-Bereich angrenzenden Source- und Draingebiete ; es verbleibt dabei als dünnes Gate-Dielektrikum in der endgültigen Feldeffekttransistorstruktur. Dazu läßt man thermisch eine dicke Oxidschicht über Source und Drain aufwachsen, wobei die im Gatebereich vorhandene Siliciumnitridschicht als oxydationshemmende Maskierung zur Verhinderung einer Dickenzunahme der dünnen Gate-Isolierschicht dient. Schließlich wird eine leitfähige Gate-Elektrode im Gatebereich gebildet, wobei die dünne Siliciumnitridschicht oder nach deren Entfernung eine andere dünne Isolierschicht weiterhin zur Abgrenzung des als Gatebereich vorgesehenen Gebietes dient.

Der hauptsächliche Fortschritt bei einer derartigen Struktur mit selbstjustiertem Gate bestand darin, daß dadurch eine verbesserte Positionierung der Gate-Elektrode und der Gate-Isolierschicht relativ zu den Source- und Draingebieten erzielt werden konnte. Vor Anwendung der selbstjustierten Gate-Strukturen mußte die Gate-Elektrode relativ zur zwischen Source und Drain wirksamen Kanallänge größer ausgelegt werden, d.h. zwischen der Gate-Elektrode und den Source- und Draingebieten lag eine zum Teil erhebliche Überlappung vor. Daraus resultierten unerwünschte Streukapazitäten in Form von Gate-Überlappungskapazitäten, die zu einer Verschlechterung der Frequenzeigenschaften bzw. der Schaltgeschwindigkeit solcher Feldeffekttransistorbauelemente in integrierten Schaltungen führten.

Obwohl die oben beschriebenen selbstjustierten Gate-Strukturen und die dazu gehörigen Verfahren bereits zu einer beträchtlichen Reduzierung der Gate-Überlappung und somit zu einer Verschnellerung der Schaltzeiten geführt haben, wurde das Problem der Gate-Überlappung der Source- und Draingebiete immer noch nicht völlig ausgeräumt. Dies lag in erster Linie an der verfahrensmäßigen Ausgestaltung, nach der die Bildung der Source- und Draingebiete trotz Vorsehung eines selbstjustierten Gates mittels eines Diffusionsschrittes erfolgte. Konventionell kann dieser Diffusionsschritt direkt durch Einbringung von Dotierungsstoffen für Source und Drain in den Halbleiterkörper in Anwesenheit der selbstjustierenden Gatemaskierung erfolgen. Alternativ können die Dotierungsstoffe zunächst durch Diffusion oder Ionenimplantation in einer Weise eingebracht werden, daß sich sehr flache Oberflächengebiete vom entsprechenden Leitungstyp bilden, woran sich ein bei hohen Temperaturen durchzuführender sog. Eintreibschritt anschließt, durch den Source und Drain tiefer in den Halbleiterkörper hineingetrieben werden. Im Verlaufe dieser Diffusions- bzw. Eintreibschritte kommt es natürlich auch bis zu einem gewissen Maße zu einer seitlichen Auswanderung der Dotierungsatome unterhalb der Gate-Maskierungsschicht. Im Ergebnis kam es damit dennoch zu einer Überlappung des Gates mit Source und Drain und den daraus sich ergebenden nachteiligen Konsequenzen.

Es wurde auch bereits im Stand der Technik, z.B. in der US-Patentschrift 3 472 712, angegeben, derartige selbstjustierte Isolierschicht-Feldeffekttransistoren unter Vermeidung jeglichen Diffusionsschrittes lediglich durch Einsatz einer Ionenimplantation herzustellen. Derartige Strukturen weisen sicherlich keine Gate-Überlappungsprobleme auf. Die durch solche Verfahren hergestellten Strukturen sind aber insofern einer Beschränkung unterworfen, als ihre Source- und Draingebiete lediglich mit einer Tiefe von 200 bis 300 nm oder weniger in den Halbleiterkörper bzw. das Substrat hineinreichen. Als Folge daraus ergeben sich für die Source- und Draingebiete hohe Widerstandswerte, d.h. Schichtwiderstände in der Größenordnung von 50 $\Omega/\square$. Obgleich derartig hohe Schichtwiderstandswerte durchaus akzeptabel für manche diskrete Feldeffekttransistorfunktionen wie auch für einfachere integrierte Schaltungen sein können, sind bei komplexeren mit Feldeffekttransistoren aufgebauten integrierten Schaltungen, bei denen die Source- und Draingebiete oder deren Verlängerungen als Teil des Verbindungsnetzwerks benutzt werden, erheblich niedrigere Schichtwiderstände in der Größenordnung von 8 bis 10 Ω/□ erforderlich. Nach dem Stand der Technik wurden Source- und Draingebiete mit derartig niedrigem Schichtwiderstand durch eines der oben beschriebenen Diffusionsverfahren zur Bildung der Source- und Draingebiete mit einer Tiefenerstreckung im Substrat in der Größenordnung von 1000 nm erzeugt. Die Ausbildung von beispielsweise 1000 nm tief reichenden Source- und Draingebieten lediglich durch Ionenimplantation ohne anschließende Diffusionsbehandlung würde, soweit sie überhaupt möglich wäre, eine erheblich kompliziertere und hinsichtlich der Anzahl einzelner Ionenimplantationsschritte sowie der zugehörigen Wahl der Energie- und Dosierungswerte aufwendigere Verfahrensausgestaltung erfordern.

Die Erfindung, wie sie in den Ansprüchen gekennzeichnet ist, löst die Aufgabe, ein hinsichtlich der überlappungsfreien Selbstjustierung von Dotierungsgebieten relativ zu einer Oberflächenschicht verbessertes Verfahren zur Herstellung einer Halbleiteranordnung, insbesondere einer Isolierschicht-Feldeffekttransistorstruktur anzugeben, bei der die überlappungsfreie Selbstjustierung auch bei relativ tief in den Halbleiterkörper reichenden Dotierungsgebieten erreicht werden kann. Zusammengefaßt werden mittels Ionenimplantation zunächst vollständig vom Material des Halbleiterkörpers eingeschlossene vergrabene Gebiete in der durch die Maskierungschicht auf der Halbleiteroberfläche festgelegten gegenseitigen Anordnung gebildet, woraufhin durch eine nachfolgende Wärmebehandlung eine gezielte Ausdehnung der in den vergrabenen Gebieten vorhandenen Dotierungsstoffe bis zum Erreichen der Halbleiteroberfläche herbeigeführt wird. Für den Fall einer Isolierschicht-Feldeffekttransistorstruktur heißt das, daß Source und Drain zunächst als vergrabene Gebiete mittels Ionenimplantation innerhalb des Halbleiterkörpers dotiert werden und die nachfolgende Wärmebehandlung zur Ausdiffusion der Dotierungsstoffe gerade soweit geführt wird, daß die obere Randzone des zunächst vergrabenen Gebiets letzlich gerade die Halbleiteroberfläche erreicht. In diesem Fall ist einerseits gewährleistet, daß der Kanalbereich stets exakt und vollständig von der Gate-Elektrode bedeckt ist, daß andererseits aber keinerlei Gate-Überlappung zu den derart ausgebildeten Source- und Draingebieten eintritt.

Im folgenden wird die Erfindung anhand von lediglich einen Ausführungsweg darstellenden Zeichnungen näher erläutert.

Es zeigen :

Fig. 1-7 schematische Querschnittsdarstellungen durch eine Feldeffekttransistorstruktur zur Erläuterung der Verfahrensabfolge im Rahmen vorliegender Erfindung, und

Fig. 8A-8C verschiedene Dotierungsprofile über die Tiefe des Draingebietes, wie sie sich zu verschiedenen Verfahrenszeitpunkten ergeben.

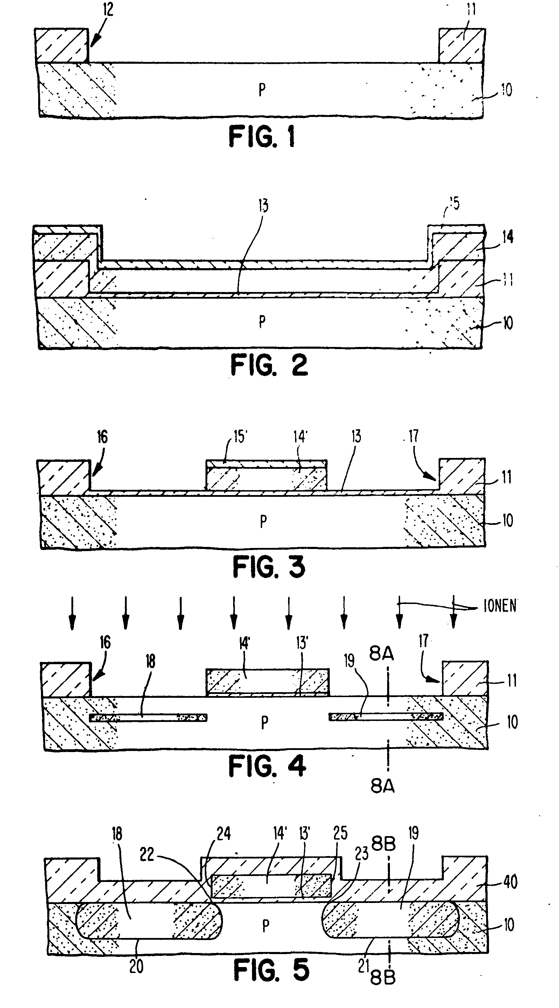

Fig. 1 zeigt einen Halbleiterkörper bzw. ein Substrat 10 vom P-Leitungstyp, dessen spezifischer Widerstandswert etwa 0,1 bis 1 Ω cm beträgt und auf dem eine größenordnungsmäßig etwa 900 nm dicke Siliciumdioxidschicht 11 gebildet ist. Diese Schicht 11 kann in konventioneller Weise durch thermische Oxydation erzeugt oder in anderer Weise niedergeschlagen werden, z.B. durch Aufdampfen oder Sputtern. In der Schicht 11 wird in konventioneller Anwendung entsprechender Photolitographie- und Ätzverfahren eine Öfnnung 12 hergestellt, so daß sich die in Fig. 1 gezeigte Struktur ergibt.

Entsprechend Fig. 2 läßt man anschließend eine dünne Schicht 13 aus Siliciumdioxid mit einer Dicke von etwa 50 nm im Bereich der Öffnung 12, vorzugsweise thermisch aufwachsen. Darüber wird mittels konventioneller Verfahren zum Niederschlagen von Silicium, beispielsweise beschrieben in der US-Patentschrift 3 424 629, eine Siliciumschicht 14 aufgebracht. Dieser Prozeßschritt wird bei einer Temperatur in der Größenordnung von 500 bis 900 °C und üblicherweise bei Atmosphärendruck durchgeführt. Bei der Siliciumschicht 14 handelt es sich um eine polykristalline Struktur, da sie auf den Siliciumdioxidschichten 11 und 13 gebildet wird. Die Dicke der Schicht 14 beträgt größenordnungsmäßig etwa 900 nm. Schließlich wird noch eine etwa 80 nm dicke Siliciumdioxidschicht 15 in an sich konventioneller Weise, vorzugsweise jedoch durch thermische Oxydation eines Teils der Oberfläche der Siliciumschicht 14, erzeugt.

Entsprechend Fig. 3 wird als nächstes unter Einsatz konventioneller Photolitographie- und Ätztechniken sowie unter Einsatz einer Maskierungsschicht 15' aus Siliciumdioxid auf dem für die spätere Gate-Elektrode des Feldeffekttransistors vorgesehenen Bereich der Siliciumschicht 14 ein selektiver Ätzvorgang zur Beseitigung der über den Bereich 14' hinausgehenden Siliciumschichtbereiche durchgeführt. Für die Beseitigung der Siliciumschicht 14 stehen alle konventionellen chemischen Ätzverfahren zur Verfügung, mit denen vorzugsweise Silicium im Gegensatz zu Siliciumdioxid geätzt werden kann. Beispielsweise eignet sich eine verdünnte Salpetersäure/Flußsäurelösung für diesen Zweck. Als Ergebnis wird ein Paar von Öffnungen 16 und 17 in Fig. 3 erhalten, die sich an den für die späteren Source- und Draingebiete bestimmten Stellen befinden.

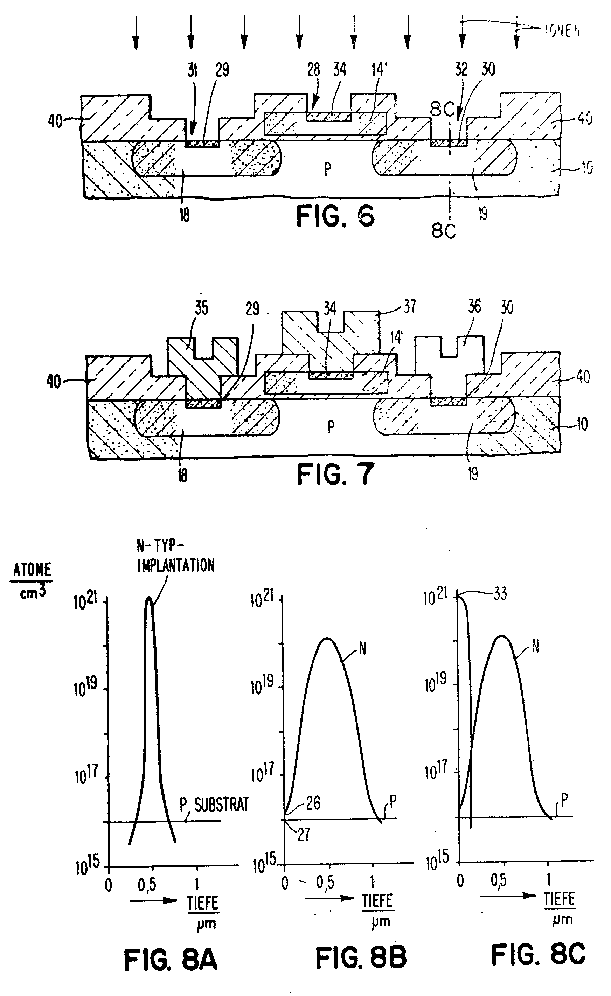

Mittels Ionenimplantation werden entsprechend Fig. 4 anschließend die im Halbleiterkörper 10 vergrabenen Gebiete 18 und 19 gebildet. Dazu werden N-leitende Dotierungsstoffe, z.B. Phosphor, in das Substrat implantiert. Der Implantationsschritt kann entweder direkt durch die unmaskierte relative dünne Siliciumdioxidschicht 13 oder entsprechend Fig. 4 nach vorheriger Entfernung der nicht durch die Siliciumschicht 14' bedeckten Siliciumdioxidschicht 13 erfolgen. In Fig. 4 ist die unterhalb der Maskierung in Form der Siliciumschicht 14' angeordnete Siliciumdioxidschicht mit 13' bezeichnet. Zur Beseitigung der Siliciumdioxidschicht kann ein konventionelles Ätzverfahren, z.B. unter Verwendung einer gepufferten Flußsäure benutzt werden. In diesem Fall wird auch die Siliciumdioxidschicht 15' entfernt werden, während die demgegenüber erheblich dickere Schicht 11 im wesentlichen unverändert verbleibt. Die Ionenimplantation muß mit einer so ausreichenden Strahldosierung und -energie durchgeführt werden, daß sich für die vergrabenen Gebiete 18 und 19 eine den folgenden Gesichtspunkten Rechnung tragende Konzentrationsverteilung ergibt. Bei dem nachfolgenden Hochtemperaturschritt bei etwa 1000 °C oder höher zur Ausdiffusion der Gebiete 18 und 19 nach unten hin bis zu den in Fig. 5 ersichtlichen Übergängen 20 und 21 soll durch dieselbe Wärmebehandlung sichergestellt sein, daß die Gebiete 18 und 19 sich auch nach oben in Richtung auf die Oberfläche des Halbleiterkörpers 10 ausweiten, so daß sie an der Halbleiteroberfläche gerade seitlich an die Silicium-Gate-Elektrode angrenzen. Um Source- und Draingebiete mit relativ geringen Schichtwiderstandswerten in der Größenordnung von 8 bis 10 $\Omega/\square$ zu erhalten, sind Eindringtiefen der unteren Halbleiterübergänge 20 und 21 in der Größenordnung von 1 $\mu$m wünschenswert. Um zu derartigen resultierenden Eindringtiefen zu kommen, sollten die zunächst implantierten Gebiete 18 und 19 in Fig. 4 mit einer solchen Strahlenergie und -dosierung erzeugt werden, daß sich ein Konzentrationsprofil entsprechend Fig. 8A ergibt. In Fig. 8A ist die Konzentrationsverteilung der N-dotierenden Verunreinigungen für die Gebiete 18 und 19 entlang der in Fig. 4 angegebenen Schnittlinie 8A-8A gezeigt. Wie aus Fig. 8A hervorgeht sind die Gebiete 18 und 19 ursprünglich als völlig im P-leitenden Halbleiterkörper 10 eingeschlossene Gebiete erzeugt, wobei eine Spitzenkonzentration etwa im Abstand von 0,5 $\mu$m von der Halbleiteroberfläche vorliegt. Der zur Ausbildung dieser Gebiete 18 und 19 mit dem gezeigten Konzentrationsprofil anwendbare Implantationsschritt kann mit konventionellen Vorrichtungen und Verfahren, wie sie beispielsweise in der US-Patentschrift 3 756 862 beschrieben sind, vorgenommen werden. Nimmt man beispielsweise Ionen des Typs $^{31}P^+$, ist ein Energiewert von 400 keV und eine Dosierung von Ungefähr $10^{16}$ Ionen/cm$^2$ angemessen. Die relativ dicken Schichten 11 und 14' verhindern, daß die implantierten Ionen in den Halbleiterkörper 10 unterhalb dieser Schichten eingebaut werden können. Durch die Implantation wird auch in dem Siliciumschichtbereich 14' eine Dotierstoffverteilung ähnlich der in Fig. 8A gezeigten Form gebildet. Dadurch wird die Schicht 14' in wünschenswerter Weise mit einem geringen Schichtwiderstand ausgestattet.

Im Anschluß an den Implantationsschritt wird ein sog. Ausdiffusions- bzw. Eintreibschritt bei einer Temperatur von etwa 950 °C in einer konventionellen oxidierenden Atmosphäre, wie z.B. Dampf, durchgeführt, um die Source- und Draingebiete 18 und 19 in die aus Fig. 5 ersichtliche Form zu bringen. Insbesondere sollen dadurch die Gebietsgrenzen nach oben hin in Richtung auf die Halbleiteroberfläche eine Ausweitung erfahren. Die sich für die Source- und Draingebiete 18 und 19 endgültig einstellende Dotierstoffverteilung entlang der in Fig. 5 gezeigten Schnittlinie 8B-8B ist in Fig. 8B gezeigt. Als Ergebnis des Oxydationsvorgangs wird eine Siliciumdioxidschicht 40 über dem Halbleiterkörper 10 sowie über der polykristallinen Silicium-Gate-Elektrode 14' gebildet.

Festzuhalten ist in diesem Zusammenhang, daß bei Vorsehung der Spitzenkonzentration der Ionenbehandlung bei einer Eindringtiefe, die etwa bei der Hälfte der letztlich angestrebten Eindringtiefe für die unteren Bereichsgrenzen von Source und Drain liegt, durch den anschließenden Diffusions- bzw. Wärmebehandlungsschritt die Source- und Draingebietsränder neben ihrer Ausweitung nach unten im gleichen Maße auch nach oben hin ausgeweitet werden, so daß ihre Schnittpunkte 22 und 23 (in Fig. 5) bezüglich ihrer seitlichen Justierung praktisch exakt mit den entsprechenden Kanten 24 und 25 der Silicium-Gate-Elektrode 14' fluchten. Um sicherzustellen, daß die Schnittpunkte 22 und 23 mindestens mit den Ecken 24 und 25 zusammenfallen, bzw. mit anderen Worten, daß die Silicium-Elektrode 14' und die darunterliegende dünne Schicht 13' aus Siliciumdioxid bis zu den Schnittpunkten 22 und 23 reichen, weist der einleitende Ionenimplantationsschritt entsprechend Fig. 8A eine solche Verteilung auf, daß im Anschluß an die Diffusions- bzw. Wärmebehandlung die abschließende Störstellenkonzentration an der Oberfläche der Gebiete 18 und 19 (Punkt 26 in Fig. 8B) bis etwa zum Faktor 3 größer ist als die Grunddotierung (Punkt 27 in Fig. 8B) des Silicium-Halbleiterkörpers 10.

Im weiteren Verfahrensablauf werden dann in der Siliciumdioxidschicht 40 Öffnungen 31, 32 und 28 als Kontaktöffnungen für Source, Drain und die Gate-Elektrode hergestellt. Wie aus Fig. 8B ersichtlich ist, weisen die Source- und Draingebiete eine relativ niedrige Oberflächenkonzentration an Phosphor auf. Von daher ist es vorteilhaft, in diesen Kontaktöffnungen jeweils eine flache Implantation von den N-Leitungstyp verursachenden Dotierungsstoffen, z.B. Phosphor, vorzunehmen, wobei die in Fig. 6 mit 29, 30 und 34 bezeichneten Gebiete gebildet werden. Diese Gebiete weisen eine hohe Oberflächenkonzentration vom N-Leitungstyp in der Größenordnung von $10^{21}$ Atomen/cm$^3$ auf, vgl. dazu das in Fig. 8C gezeigt Konzentrationsprofil für die in Fig. 6 gezeigten Verhältnisse, und insbesondere den Punkt 33 in Fig. 8C. Diese N+ leitenden Anschlußgebiete 29, 30 und 34 können in konventioneller Weise durch Einbringen von Dotierungsstoffen erzeugt werden. Es ist jedoch vorzuziehen, diese Gebiete durch Implantation von N-leitenden Ionen, z.B. Phosphor, unter Benutzung des oben beschriebenen Verfahrens mit einer Energie von ungefähr 40 keV und einer Dosierung von etwa $10^{16}$ Ionen/cm$^2$ herzustellen. Im letzten Verfahrensschritt entsprechend der Darstellung von Fig. 7 wird in konventioneller Weise die Kontakt- und Verbindungsmetallisierung in Form der Anschlüsse 35, 36 und 37 für Source, Drain und das Silicium-Gate ausgebildet. Diese Metallisierung kann völlig konventionell in der bei derartigen integrierten FET-Schaltungen üblichen Weise, z.B. aus Aluminium, bestehen.

Soweit in dem beschriebenen Ausführungsbeispiel auf eine Struktur mit einem selbstjustierten Silicium-Gate abgestellt wurde, ist festzuhalten, daß die Erfindung darauf nicht beschränkt ist sondern auch auf andere selbstjustierte Gate-Ausführungen angewendet werden kann. Dabei ist lediglich zu beachten, daß die zur Sicherstellung der Selbstjustierung der dünnen Gate-Isolierschicht erforderliche Maskierungsschicht aus einem Material besteht, das bei den zur Anwendung kommenden Diffusionstemperaturen in der Größenordnung von 1000 °C oder größer nicht schmilzt oder sich in anderer Weise zersetzt. Zu solchen anderen Möglichkeiten gehören beispielsweise selbstjustierte Feldeffekttransistoren mit einer Siliciumnitrid-Gate-Technologie, bei der eine dünne Schicht aus Siliciumnitrid zur selbstjustierenden Bildung der Source- und Draingebiete relativ zur dünnen Gate-Isolierschicht dient. Weiterhin lassen sich im Rahmen eines solchen Verfahrens hochtemperaturfeste Metalle, z.B. Molybdän, Wolfram oder Tantal anstelle von dem im vorliegenden Ausführungsbeispiel beschriebenen Silicium einsetzen.

**Ansprüche**

1. Verfahren zur Herstellung einer Halbleiteranordnung mit Selbstjustierung von Dotierungsgebieten relativ zu Gate-Oberflächenschichten, insbesondere einer Isolierschicht-Feldeffekttransistorstruktur, bei dem unter Einsatz eines Ionenimplantationsschrittes in einem Halbleiterkörper eines ersten Leitungstyps mindestens zwei Dotierungsgebiete eines zweiten Leitungstyps, insbesondere Source- und Draingebiete, in einem Abstand voneinander gebildet werden, wobei auf dem Halbleiterkörper wenigstens im Bereich dieses Abstandes eine gegenüber der Ionenbestrahlung wirksame Maskierungsschicht aufgebracht ist, dadurch gekennzeichnet, daß man einen Strahl von den zweiten Leitungstyp erzeugenden Ionen mit so ausreichender Strahlenenergie und -dosierung auf den Halbleiterkörper gerichtet einwirken läßt, daß zunächst vollständig vom Material des Halbleiterkörpers (10) eingeschlossene und demgegenüber entgegengesetzt dotierte vergrabene Gebiete (18, 19) in der durch die Maskierungsschicht (14') bestimmten gegenseitigen Anordnung gebildet werden (Fig. 4), und daß in Gegenwart der wenigstens im Bereich des Abstandes vorhandenen Maskierungsschicht (14') durch eine nachfolgende Wärmebehandlung eine Ausdehnung der derart gebildeten vergrabenen Gebiete (18, 19) bis zum Erreichen der Halbleiteroberfläche herbeigeführt wird (Fig. 5).

2. Verfahren nach Anspruch 1, gekennzeichnet durch einen Halbleiterkörper aus Silicium sowie eine den Abstand zwischen den Dotierungsgebieten festlegende Maskierungsschicht aus der Zusammensetzung einer elektrisch isolierenden Schicht auf dem Halbleiterkörper und einer darüber gebildeten Schicht aus Silicium.

3. Verfahren nach Anspruch 2, dadurch gekennzeichnet, daß die elektrisch isolierende Schicht Siliciumdioxid umfaßt.

4. Verfahren nach einem der vorhergehenden Ansprüche, dadurch gekennzeichnet, daß die Maskierungsschicht wenigstens im Bereich des Abstandes zwischen den zu erstellenden Dotierungsgebieten eine Lage aus Siliciumnitrid umfaßt.

5. Verfahren nach einem der vorhergehenden Ansprüche, dadurch gekennzeichnet, daß die Wärmebehandlung in einer Weise durchgeführt wird, daß die zu den Dotierungsgebieten gehörigen Halbleiterübergänge (20, 21 in Fig. 5) im Zuge ihrer durch die Wärmebehandlung bedingten Ausdehnung die Halbleiteroberfläche an den Kantenpunkten (22, 23) der den Abstand festlegenden Maskierungsschicht (14') schneiden.

6. Verfahren nach einem der vorhergehenden Ansprüche, dadurch gekennzeichnet, daß die Oberflächenkonzentration der die Dotierungsgebiete vom zweiten Leitungstyp bestimmenden Dotierungsstoffe bis etwa zum Faktor 3 größer ist als die Grunddotierung des Halbleiterkörpers von ersten Leitungstyp.

7. Verfahren nach einem der vorhergehenden Ansprüche, dadurch gekennzeichnet, daß der Ionenimplantationsschritt durch eine die Halbleiteroberfläche im Bereich der Öffnungen in der Maskierungsschicht bedeckende Schicht, vorzugsweise aus Siliciumdioxid, durchgeführt wird.

8. Verfahren nach einem der vorhergehenden Ansprüche, dadurch gekennzeichnet, daß nach der Ausbildung von Anschlußöffnungen zu den Dotierungsgebieten und vor der Herstellung der zugehörigen Metallisierung in die im Bereich der Anschlußöffnungen (28, 31, 32 in Fig. 6) freigelegten Bereiche zusätzliche Dotierungsstoffe des zweiten Leitungstyps zur Erhöhung der Oberflächenkonzentration, vorzugsweise ebenfalls mittels eines Ionenimplantationsschrittes, eingebracht werden.

**Claims**

1. Method for making a semiconductor device with selfalignment of doping regions relative to gate surface layers, in particular of an isolation layer field effect transistor structure, wherein, utilizing an ion implantation step, at least two doping regions of a second conductivity type, in particular source and drain regions, are formed with spacing between each other in a semiconductor body of a first conductivity type, and wherein on the semiconductor body at least in the area of said spacing, an ion beam masking layer is applied, characterized in that an ion beam generating the second conductivity type is permitted to act on the semiconductor body at energy and dosage levels sufficient to form buried regions (18, 19), which are initially fully enclosed within and oppositely doped to said semiconductor body (10), in the mutual structure (Fig. 4) defined by the masking layer (14'), and that by a subsequent heat treatment in the presence of masking layer (14') existing at least in the area of the spacing, the buried regions (18, 19) thus formed are caused to extend until they reach the semiconductor surface (Fig. 5).

2. Method in accordance with claim 1, characterized by a semiconductor body of silicon as well as by a masking layer defining the spacing between the doping regions, which comprises an electrically insulative layer on the semiconductor body and a layer of silicon formed thereon.

3. Method in accordance with claim 2, characterized in that the electrically insulative layer comprises silicon dioxide.

4. Method in accordance with any one of the preceding claims, characterized in that the masking layer comprises a layer of silicon nitride at least in the area of the spacing between the doping regions to be formed.

5. Method in accordance with any one of the preceding claims, characterized in that the heat treatment is effected in such a manner that the semiconductor junctions (20, 21 in Fig. 5), belonging to the doping regions, in the course of their extension caused by the heat treatment intersect the semiconductor surface at the edge points (22, 23) of the masking layer (14') defining the spacing.

6. Method in accordance with any one of the preceding claims, characterized in that the surface concentration of the dopants determining the doping regions of the second conductivity type exceed by a factor of up to about 3 the background doping of the semiconductor body of the first conductivity type.

7. Method in accordance with any one of the preceding claims, characterized in that the ion implantation step is effected through a layer, preferably of silicon dioxide, covering the semiconductor surface in the area of the openings in the masking layer.

8. Method in accordance with any one of the preceding claims, characterized in that after formation of the contact openings to the doping regions and prior to the formation of the accompanying metalization, additional dopants of the second conductivity type for increasing the surface concentration, preferably also using an ion implantation step, are introduced into the exposed regions in the area of the contact openings (28, 31, 32 in Fig. 6).

**Revendications**

1. Procédé de fabrication d'un dispositif semi-conducteur pour l'auto-alignement présentant des régions dopées auto-alignées par rapport à une région de porte, en particulier d'une structure de transistors à effet de champ à porte isolée, dans lequel sont formées, par une implantation d'ions dans un corps semi-conducteur d'un premier type de conductivité, au moins deux régions dopées d'un second type de conductivité, par exemple des régions source et drain, espacée l'une de l'autre, une couche de masquage contre le bombardement ionique ayant été préalablement déposée sur le corps semi-conducteur au moins dans la zone entre ces régions, caractérisé en ce qu'un faisceau d'ions du second type de conductivité est dirigé sur le corps semi-conducteur avec une énergie et une dose suffisantes pour former des régions enterrées (18, 19), complètement entourées par le matériau du corps semi-conducteur (10) du type de conductivité opposé à ce dernier (Figure 4) selon une configuration déterminée par la couche de masquage (14'), et en ce que, par un traitement thermique ultérieur pendant lequel la couche de masquage (14') est présente au moins dans ladite zone entre les régions, les régions enterrées (18, 19) ainsi formées s'étalent jusqu'à ce qu'elles atteignent la surface semi-conductrice (Figure 5).

2. Procédé selon la revendication 1, caractérisé en ce que le corps semi-conducteur est en silicium et que la couche de masquage déterminant l'espace entre les régions dopées, est composée d'une couche électriquement isolante disposée sur le corps semi-conducteur recouverte par une couche de silicium.

3. Procédé selon la revendication 2, caractérisée en ce que la couche électriquement isolante comporte une couche de dioxyde de silicium.

4. Procédé selon l'une quelconque des revendications précédentes, caractérisé en ce que la couche de masquage comporte une couche de nitrure de silicium au moins dans ladite zone entre les régions dopées.

5. Procédé selon l'une quelconque des revendications précédentes, caractérisé en ce que le traitement thermique est effectué de telle sorte que les jonctions semi-conductrices (20, 21 de la Figure 5), appartenant aux régions de dopage après étalement atteignent la surface semi-conductrice aux points (22, 23) de la couche de masquage (14') déterminant l'espacement desdites régions.

6. Procédé selon l'une quelconque des revendications précédentes, caractérisé en ce que la concentration de surface des dopants déterminant les régions dopées du second type de conductivité est plus grande, par un facteur allant jusqu'à environ 3, que le dopage de base du corps semi-conducteur du premier type de conductivité.

7. Procédé selon l'une quelconque des revendications précédentes, caractérisé en ce que l'étape d'implantation ionique est effectuée à l'aide d'une couche, de préférence en dioxyde de silicium, couvrant la surface semi-conductrice dans les portions exposées de la couche de masquage.

8. Procédé selon l'une quelconque des revendications précédentes caractérisé en ce que, après la formation des ouvertures destinées à permettre le contact avec les régions dopées, et avant la formation de la métallisation relative à ces contacts, on augmente la concentration de surface en introduisant des dopants supplémentaires du second type de conductivité dans les régions exposées à travers les ouvertures de contact (28, 31, 32 de la Figure 6) et ce de préférence par une étape d'implantation ionique.

FIG. 1

FIG. 2

FIG. 3

FIG. 4

FIG. 5

FIG. 6

FIG. 7

FIG. 8A

FIG. 8B

FIG. 8C